# EUROPÄISCHE PATENTSCHRIFT

(11) **EP 3 160 974 B1**
(45) Veröffentlichungstag und Bekanntmachung des Hinweises auf die Patenterteilung: **15.08.2018**
(21) Anmeldenummer: 15732632.3
(22) Anmeldetag: 25.06.2015
(51) Int. Cl.: C07F 9/50, C07F 9/6561, C07F 1/08, H01L 51/50, H01L 51/00

(54) **ZWEIKERNIGE METALL(I)-KOMPLEXE MIT TETRADENTATEN LIGANDEN FÜR OPTOELEKTRONISCHE ANWENDUNGEN**
BINUCLEAR METAL (I) COMPLEXES WITH TETRADENTATE LIGANDS FOR OPTOELECTRONIC APPLICATIONS
COMPLEXES MÉTAL(I) À DEUX AVEC DES LIGANDS TETRADENTÉS POUR DES APPLICATIONS OPTOÉLECTRONIQUES

(30) Priorität: 30.06.2014 EP 14174987; 22.12.2014 EP 14199713
(43) Veröffentlichungstag der Anmeldung: 03.05.2017
(73) Patentinhaber: cynora GmbH, 76646 Bruchsal (DE)
(72) Erfinder: ZINK, Daniel, 76646 Karlsruhe (DE); VOLZ, Daniel, 76137 Karlsruhe (DE); FRIEDRICHS, Jana, 76137 Karlsruhe (DE)
(74) Vertreter: Hoppe, Georg Johannes
(86) Internationale Anmeldenummer: PCT/EP2015/064422
(87) Internationale Veröffentlichungsnummer: WO 2016/001064

(56) Entgegenhaltungen:
- EP-A1- 2 749 563
- HONG-YU ZHANG ET AL: "Di- and Tetranuclear Metal Complexes with Phenoxo Bridges: Synthesis, Structures, and Photoluminescent and Electroluminescent Properties", INORGANIC CHEMISTRY, Bd. 45, Nr. 4, 1. Februar 2006 (2006-02-01), Seiten 1745-1753, XP055176228, ISSN: 0020-1669, DOI: 10.1021/ic051531x
- Joseph C. Deaton ET AL: "E-Type Delayed Fluorescence of a Phosphine-Supported Cu 2 ([mu]-NAr 2 ) 2 Diamond Core: Harvesting Singlet and Triplet Excitons in OLEDs ∥", Journal of the American Chemical Society, vol. 132, no. 27, 17 June 2010 (2010-06-17), pages 9499-9508, XP055031756, ISSN: 0002-7863, DOI: 10.1021/ja1004575
- Daniel M. Zink ET AL: "Synthesis, Structure, and Characterization of Dinuclear Copper(I) Halide Complexes with P^N Ligands Featuring Exciting Photoluminescence Properties", Inorganic Chemistry, vol. 52, no. 5, 4 March 2013 (2013-03-04), pages 2292-2305, XP055136105, ISSN: 0020-1669, DOI: 10.1021/ic300979c

## Beschreibung

Die Erfindung betrifft zweikernige Metall(I)komplexe mit tetradentaten Liganden gemäß Anspruch 1, insbesondere zur Verwendung in optoelektronischen Bauelementen.

### Einleitung

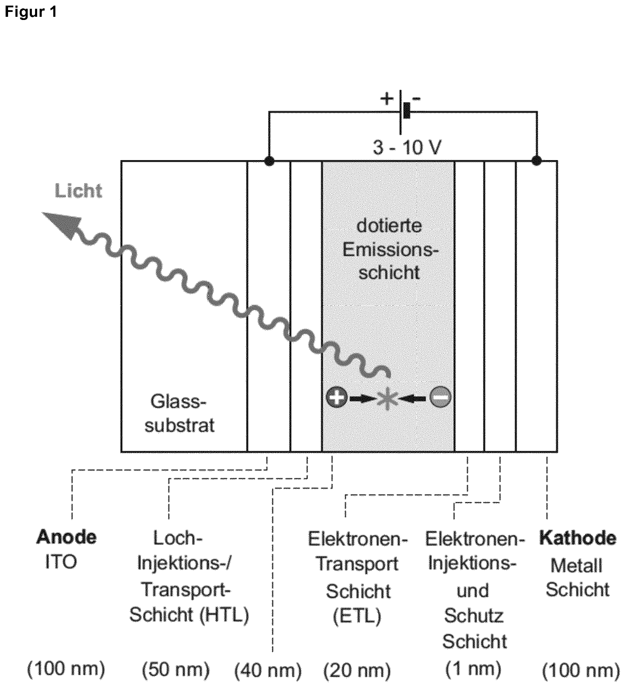

Zurzeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der *OLED*s, den Organic *L*ight Emitting Diodes, die in Figur 1 schematisch und vereinfacht dargestellt ist.

Derartige Bauteile bestehen vorwiegend aus organischen Schichten, wie in Figur 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet.

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

In den letzten Jahren werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch erhebliche Probleme. So sind die physikalischen Eigenschaften von phosphoreszierenden OLEDs im Hinblick auf die Stabilität der Metallkomplexe, Effizienz, Betriebsspannung und Lebensdauer noch nicht ausreichend für die Verwendung von Triplettemittern in hochwertigen und langlebigen Elektrolumineszenzvorrichtungen. Hier sind daher weitere Verbesserungen erforderlich. Auch bei anderen in organischen Elektrolumineszenzvorrichtungen verwendeten Verbindungen, wie beispielsweise Matrixmaterialien und Ladungstransportmaterialien, sind noch weitere Verbesserungen erforderlich.

INORGANIC CHEMISTRY, Bd. 45, Nr. 4, 2006, Seiten 1745-1753 ("Di- and Tetranuclear Metal Complexes with Phenoxo Bridges: Synthesis, Structures, and Photoluminescent and Electroluminescent Properties") offenbart Verbindungen (1) und (2), ihre Herstellung und ihre Verwendung in OLEDs.

### Beschreibung der Erfindung

Überraschend wurde gefunden, dass bestimmte organische Elektrolumineszenzvorrichtungen enthaltend die unten näher beschriebenen Metallchelatkomplexe zu deutlichen Verbesserungen der organischen Elektrolumineszenzvorrichtung führen, insbesondere hinsichtlich der Lebensdauer, der Effizienz und der Stabilität gegenüber Temperaturbelastung. Dies gilt insbesondere für grün und blau lumineszierende Elektrolumineszenzvorrichtungen.

Die Beschreibung betrifft in einem Aspekt zweikernige Metall(I)komplexe der Form M₂X₂L, die eine Struktur gemäß Formel A aufweisen, wobei L einen vierzähnigen Ligand darstellt. Die Formel A und die Struktur des Liganden L ist unten näher erläutert.

Die erfindungsgemäßen Komplexe zeichnen sich unter anderem durch folgende Vorteile aus: Durch die Verwendung von vierzähnigen chelatisierenden Liganden L treten bei Eintrag von thermischer Energie keine chemischen Reaktionen auf wie etwa die Abspaltung von labilen Liganden oder die Bildung von alternativen Strukturen.

Durch die Wechselwirkung von permanenten bzw. induzierten Dipolen steigt die nötige Energie, um Moleküle aus dem Festkörperverband in die Gasphase zu bringen. Das Dipolmoment wird durch das Inversionszentren verringert, wodurch ein externes Dipolmoment von 0 Debye erzielt wird.

Neben Verdampfungsverfahren sind die beschriebenen Komplexe auch für die Flüssigprozessierung geeignet. Auch hierbei zeigen sich die Vorteile der vierzähnigen Liganden, die auch in Lösung auftretende Dissoziationsprozesse wirksam unterdrücken können.

Die Beschreibung betrifft in einem Aspekt zweikernige Metall(I)komplexe der Form M₂X₂L, die eine Struktur gemäß Formel A aufweisen oder von einer Struktur nach Formel A sind:

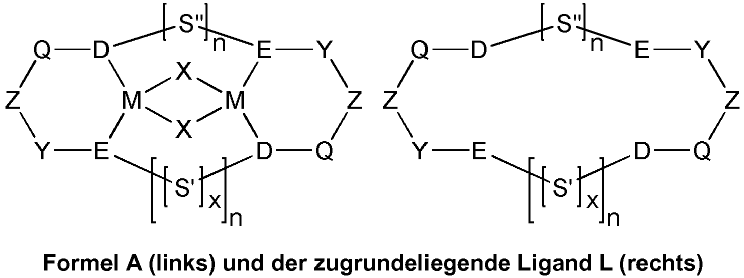

In Formel A (nachfolgend auch als M₂X₂L bezeichnet) steht L für einen tetradentaten Liganden, der sich aus zwei gleichen oder verschiedenen Untereinheiten EnD zusammensetzt, die über mindestens eine Spacereinheit S" (und optional S') verbunden sind, die D und E verbindet. Die Untereinheit EnD bindet über ein Donoratom D* und ein Donoratom E*, die unabhängig voneinander ausgewählt sind aus der Gruppe bestehend aus N, wobei N kein Imin-Stickstoffatom oder Teil eines N-heteroaromatischen Rings ist, P, C*, O, S, As und Sb an den M₂X₂-Kern, so dass sich ein 6-gliedriger Metallazyklus ausbildet, wobei die beiden Donoratome D* und E* verschieden voneinander sind und durch die drei Einheiten Q, Y, Z verbunden sind und somit eine zweizähnige Untereinheit EnD ergeben, und wobei in einer Ausführungsform die folgenden Kombinationen aus D* und E* zulässig sind:

| | | | | | | | | | | | | | | |
|---|---|---|---|---|---|---|---|---|---|---|---|---|---|---|
| D* = | N | N | N | N | N | N | P | P | P | P | P | C* | C* | C* |
| E* = | P | C* | O | S | As | Sb | N | C* | O | As | Sb | N | P | O |

| | | | | | | | | | | | | | | |
|---|---|---|---|---|---|---|---|---|---|---|---|---|---|---|
| D* = | C* | C* | C* | O | O | O | O | O | O | S | S | S | S | S |
| E* = | S | As | Sb | N | P | C* | S | As | Sb | N | C* | O | As | Sb |

| | | | | | | | | | | | | | | |
|---|---|---|---|---|---|---|---|---|---|---|---|---|---|---|
| D* = | As | As | As | As | As | As | Sb | Sb | Sb | Sb | Sb | Sb | | |
| E* = | N | P | C* | O | S | Sb | N | P | C* | O | S | As | | |

Die Spacereinheiten S" und S' der Formel sind bei jedem Auftreten gleich oder verschieden ein substituiertes oder unsubstituiertes Atom der dritten, vierten, fünften oder sechsten Hauptgruppe, welches jeweils die zwei Untereinheiten EnD verbindet. Wenn D* oder E* ein Carben-C* oder ein =O ist, ist die Spacereinheit S" und S' nicht direkt daran gebunden, sondern über ein zusätzliches Atom A/G oder Y**, wobei A/G und Y** wie bei den Unterformeln I bis IX definiert ist. In einer Ausführungsform sind die Spacereinheiten S" und S' bei jedem Auftreten gleich oder verschieden BR¹, B(R¹)₂⁻, C(R¹)⁻, C(R¹)₂, Si(R¹)⁻, Si(R¹)₂, C(=O), C(=NR¹), N⁻, NR¹, N(R¹)₂⁺, PR¹, P(R¹)₂⁺, AsR¹, As(R¹)₂⁺, P(=O)R¹, As(=O)R¹, P(=S)R¹, As(=S)R¹, O, S, S(R¹)⁺, Se, Te, S(=O), S(=O)₂, Se(=O), Se(=O)₂, Te(=O) oder Te(=O)₂.
R¹ ist bei jedem Auftreten gleich oder verschieden H, Deuterium, F, Cl, Br, I, N(R²)₂, CN, CF₃, NO₂, Si(R²)3, B(OR²)2, C(=O)R², P(=O)(R²)2, S(=O)R², S(=O)₂R², OSO₂R², eine Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können in einer Ausführungsform zwei oder mehrere dieser Substituenten R¹ auch miteinander ein mono- oder polycyclisches, aliphatisches, aromatisches und/oder benzoannelliertes Ringsystem bilden.
R² ist bei jedem Auftreten gleich oder verschieden H, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R² auch miteinander ein mono- oder polycyclisches, aliphatisches oder aromatisches Ringsystem bilden.
In einer Ausführungsform können die Reste R¹, welche in derselben Spacereinheit S" oder S' gebunden sind, auch miteinander ein Ringsystem bilden. So können auch zwei Reste R¹, welche an dasselbe Kohlenstoffatom gebunden sind, beispielsweise wenn die Spacereinheit S" oder S' für C(R¹)₂ steht, miteinander ein Ringsystem bilden und so zu Spiro-Strukturen führen. Beispiele für mögliche Ringsysteme sind hier fluorenartige Gruppen, wenn beide Gruppen R¹ für Phenylgruppen stehen, die miteinander ein Ringsystem bilden, oder 1,3-Dioxolane, wenn beide Gruppen R¹ für Alkoxygruppen stehen, die miteinander ein Ringsystem bilden.
In einer weiteren Ausführungsform können auch Reste R¹, welche an der Spacereinheit S" oder S' gebunden sind, mit Resten R, welche an der Untereinheit E∩D gebunden sind, miteinander ein Ringsystem bilden.
n ist bei jedem Auftreten gleich oder verschieden 2 bis 20, insbesondere 3 bis 15, in einer Ausführungsform 4 bis 12.
x ist entweder 0 oder 1, wobei x = 0 bedeutet, dass der Spacer S' nicht vorhanden ist, aber auch keine direkte Bindung zwischen E und D vorhanden ist.
X steht unabhängig voneinander für Cl, Br, I, CN, OCN, SCN, Alkinyl, Thiolat und/oder N₃, M steht unabhängig voneinander für Cu und Ag. C* steht für ein divalentes Carben-Kohlenstoffatom. Bei ∩ handelt es sich um eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise alkylische und arylische Amine und Alkoxygruppen als Donor, bzw Carboxylate und deren Ester, Carbonyl, Nitril und CF₃-Gruppen als Akzeptor. Beide Einheiten EnD können auch weiter substituiert und/oder anneliert sein und sind miteinander verbunden, so dass sich ein vierzähniger Ligand ergibt.
Q ist sowohl mit D als auch mit Z verbunden, wobei eine erste Bindung zwischen einem Atom Q* des Substituenten Q und einem Atom D* des Substituenten D ausgebildet wird, und wobei eine zweite Bindung zwischen einem Atom Q* des Substituenten Q und einem Atom Z* des Substituenten Z ausgebildet wird. Analoges gilt für Y, eine erste Bindung wird zwischen einem Atom Y* des Substituenten Y und einem Atom E* des Substituenten E ausgebildet, und eine zweite Bindung zwischen einem Atom Y* des Substituenten Y und einem Atom Z* des Substituenten Z ausgebildet. Analoges gilt für Z, eine erste Bindung wird zwischen einem Atom Z* des Substituenten Z und einem Atom Q* des Substituenten Q* ausgebildet, und eine zweite Bindung zwischen einem Atom Z* des Substituenten Z und einem Atom Y* des Substituenten Y ausgebildet. Q*, Y* und Z* sind unabhängig voneinander ausgewählt aus der Gruppe bestehend aus C, N, O, S und P.
Folgende Kombinationen direkt benachbarter Atome D*, E*, Q*, Y* und Z* sind in einer Ausführungsform der Beschreibung nicht zulässig: P-N, N-As, N-Sb, O-O, P-P, P-As, P-Sb.
Jedes R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Eine Arylgruppe im Sinne dieser Beschreibung enthält 6 bis 40 C-Atome; eine Heteroarylgruppe im Sinne dieser Beschreibung enthält 2 bis 39 C-Atome und mindestens ein Heteroatom, mit der Massgabe, dass die Summe aus C-Atomen und Heteroatomen mindestens 5 und höchstens 40 ergibt. Die Heteroatome sind insbesondere ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein cyclisches Carben im Sinne dieser Beschreibung ist eine cyclische Gruppe, welche über ein neutrales C-Atom an das Metall bindet. Dabei kann die cyclische Gruppe gesättigt oder ungesättigt sein. Möglich sind auch Arduengo-Carbene, also solche Carbene, bei welchen an das Carben-C-Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Beschreibung angesehen.

Unter einer Aralkylgruppe im Sinne der vorliegenden Beschreibung werden Alkylgruppen verstanden, insbesondere die unten aufgeführten Alkylgruppen, welche mit einer Aryl- oder Heteroarylgruppe, insbesondere einer der unten aufgeführten Aryl- oder Heteroarylgruppen, substituiert sind.

Ein aromatisches Ringsystem im Sinne dieser Beschreibung enthält 6 bis 60 C-Atome im Ringsystem. Ein heteroaromatisches Ringsystem im Sinne dieser Beschreibung enthält 2 bis 59 C-Atome und mindestens ein Heteroatom im Ringsystem, mit der Massgabe, dass die Summe aus C-Atomen und Heteroatomen mindestens 5 und höchstens 60 ergibt. Die Heteroatome sind in einer Ausführungsform ausgewählt aus N, O und/oder S. Unter einem aromatischen oder heteroaromatischen Ringsystem im Sinne dieser Beschreibung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein sp³-hybridisiertes C-, N- oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Beschreibung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Beschreibung werden unter einer C1- bis C40- Alkylgruppe bzw. C1-bis C20-Alkylgruppe, in der auch einzelne H-Atome oder CH2-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, Cyclopentyl, n-Hexyl, s-Hexyl, t-Hexyl, 2-Hexyl, 3-Hexyl, Cyclohexyl, 2- Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Heptenyl, Cycloheptenyl, Octenyl oder Cyclooctenyl verstanden. Unter einer Alkinylgruppe werden beispielsweise Ethinyl, Propinyl, Butinyl, Pentinyl, Hexinyl, Heptinyl oder Octinyl verstanden. Unter einer C1- bis C40- Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Phenanthren, Benzanthracen, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3- Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einer organischen elektronischen Vorrichtung wird eine elektronische Vorrichtung verstanden, welche Anode, Kathode und mindestens eine Schicht enthält, wobei diese Schicht mindestens eine organische Verbindung enthält. Die erfindungsgemäße organische elektronische Vorrichtung enthält also Anode, Kathode und mindestens eine Schicht, welche mindestens eine Verbindung nach Anspruch 1 enthält. Dabei sind insbesondere organische elektronische Vorrichtungen ausgewählt aus der Gruppe bestehend aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß Anspruch 1.

Unter einem Donoratom im Sinne der vorliegenden Beschreibung wird ein Atom verstanden, das mindestens ein freies Elektronenpaar aufweist und dadurch in der Lage ist, an ein Metallatom bzw.

Metallion zu binden. Dabei kann das Donoratom neutral oder negativ oder positiv geladen sein. In einer Ausführungsform ist das Donoratom neutral. Beispiele für neutrale Donoratome sind Phosphor oder Stickstoff, welcher in einem Heteroaromaten wie z. B. Pyridin gebunden ist, oder Kohlenstoff in Form eines Carbens. Weitere Beispiele für Donoratome sind Sauerstoff in Form eines Phenolats, Schwefel in Form eines Thiolats, Stickstoff in Form eines Nitrils, Amins, Imins, Amids oder Imids, Phosphor in Form eines Phosphins oder Phosphits oder Kohlenstoff in Form eines Isonitrils oder Acetylids.

Beispiele für neutrale Donoratome sind Phosphor in Form eines Phosphins oder Phosphits oder Phosphonits, Stickstoff in Form eines Amins oder Amids, Kohlenstoff in Form eines Carbens, Sauerstoff in Form eines oxidierten Kohlenstoffatom (Carbonyl-O) oder eines oxidierten Schwefelatoms (SO oder SO₂) oder eines oxidierten Phosphoratoms (POR₃), Schwefel in Form eines Thioethers.

Bei dem Liganden L handelt es sich um einen tetradentaten makrocyclischen Liganden, welcher über die Fragmente E und D an das Metall M bindet. Unter einem Makrocyclus im Sinne dieser Beschreibung wird ein Cyclus verstanden, welcher mindestens 10 Ringatome aufweist. Der Ligand L weist in einer Ausführungsform vier Koordinationsstellen auf. Auch wenn der Komplex der Formel A bzw. der Ligand L planar gezeichnet sind, sind diese Strukturen nicht notwendigerweise planar.

Aus der Unterschiedlichkeit von D und E resultiert ein unsymmetrischer Ligand und daraus folglich ein Komplex mit sehr niedriger Symmetrie (wenig Symmetrieoperationen möglich), der im Gegensatz zu hoch-symmetrischen Komplexen (viele Symmetrieoperationen möglich) eine sehr geringe Neigung hat zu kristallisieren. Da Materialien für optoelektronische Vorrichtungen wie OLEDs amorphe Schichten ausbilden müssen, da polykristalline Bereiche gebildete Excitonen strahlungslos löschen, sind Verbindungen mit einer hohen Kristallinität ungeeignet, da hierbei Entmischungseffekte und Konzentrationsquenching auftreten können. In nicht stabilen Filmen, die während des Betriebs der OLED kristallisieren, können die Korngrenzen der Kristalle als Fallenzustände agieren. Daher ist ein wichtiges Kriterium für die Entwicklung organischer Funktionsmaterialien optoelektronischer Vorrichtungen wie OLEDs die Beständigkeit des amorphen Zustandes. Thermische Beanspruchung während des Betriebes einer OLED kann zu einem Übergang des metastabilen amorphen Zustandes zum thermodynamisch stabilen Kristall führen. Dies hat weitreichende Konsequenzen für die Lebensdauer des Bauteiles. Die Korngrenzen einzelner Kristallite stellen Fehlstellen dar, an denen der Transport von Ladungsträgern zum Erliegen kommt. Ebenso führt die mit der Kristallisation einhergehende Umstrukturierung der Schichten zu einem verminderten Kontakt der Schichten untereinander und mit den Elektroden. Dies führt beim Betrieb mit der Zeit zum Auftreten von dunklen Stellen ("dark spots") und letztlich zur Zerstörung der OLED.

Der Ligand L kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Spezielle Ausführungsformen der zweikernigen Metall(I)komplexe der Formel A werden durch die Verbindung der Formeln I bis IX dargestellt und im Folgenden erläutert. 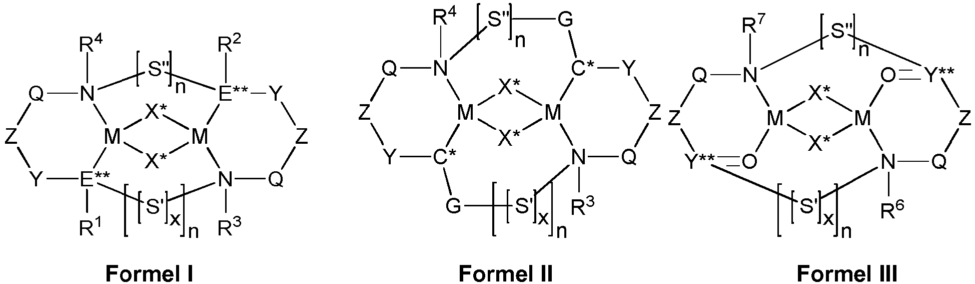 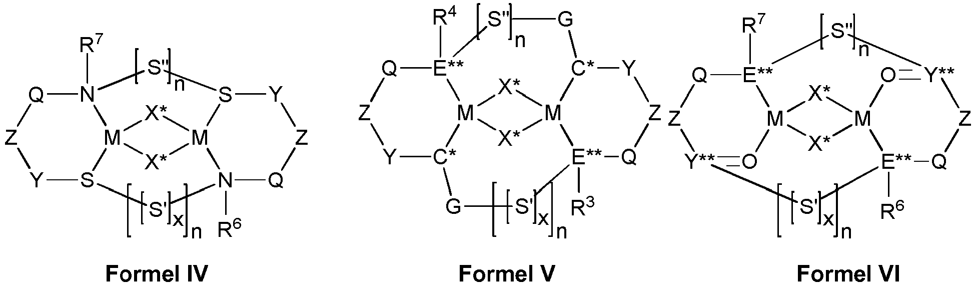 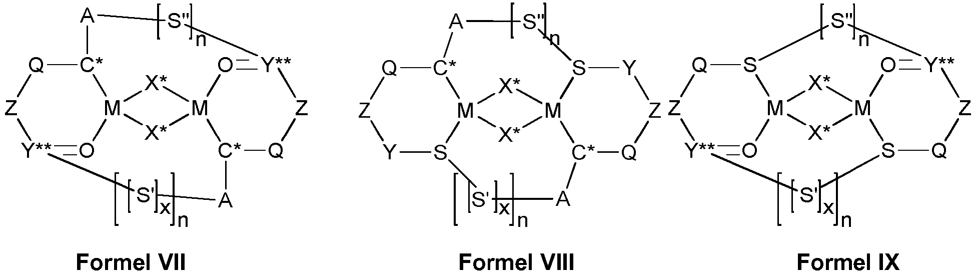 mit:
X* = unabhängig voneinander ausgewählt aus der Gruppe bestehend aus Cl, Br, I, CN, OCN, SCN, Alkinyl, Thiolat und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Y** = unabhängig voneinander ausgewählt aus der Gruppe bestehend aus C, PR, S, S(O);
Spacereinheit S" und S' = bei jedem Auftreten gleich oder verschieden ein substituiertes oder unsubstituiertes Atom der dritten, vierten, fünften oder sechsten Hauptgruppe, welches jeweils die zwei Untereinheiten EnD verbindet. Wenn das an das Metallzentrum M koordinierende Atom ein Carben-C*-Atom oder ein =O-Atom ist, ist die Spacereinheit S" und S' nicht direkt daran gebunden, sondern über ein zusätzliches Atom A/G oder Y**. In einer Ausführungsform sind die Spacereinheiten S" und S' bei jedem Auftreten gleich oder verschieden BR¹, B(R¹)₂⁻, C(R¹)⁻, C(R¹)₂, Si(R¹)⁻, Si(R¹)₂, C(=O), C(=NR¹), N⁻, NR¹, N(R¹)₂⁺, PR¹, P(R¹)₂⁺, AsR¹, As(R¹)₂⁺, P(=O)R¹, As(=O)R¹, P(=S)R¹, As(=S)R¹, O, S, S(R¹)⁺, Se, Te, S(=O), S(=O)₂, Se(=O), Se(=O)₂, Te(=O) oder Te(=O)₂.
R¹ ist bei jedem Auftreten gleich oder verschieden H, Deuterium, F, Cl, Br, I, N(R²)₂, CN, CF₃, NO₂, Si(R²)3, B(OR²)2, C(=O)R², P(=O)(R²)2, S(=O)R², S(=O)₂R², OSO₂R², eine Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme.
R² ist bei jedem Auftreten gleich oder verschieden H, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R² auch miteinander ein mono- oder polycyclisches, aliphatisches oder aromatisches Ringsystem bilden;

n ist bei jedem Auftreten gleich oder verschieden 2 bis 20, insbesondere 3 bis 15, in einer Ausführungsform 4 bis 12.
x ist entweder 0 oder 1, wobei x = 0 bedeutet, dass der Spacer S' nicht vorhanden ist.
R = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁴, R⁶, R⁷ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. Die Reste R²-R⁴, R⁶ und R⁷ können optional auch zu annelierten Ringsystemen führen.

Die Einheiten QC*A und YC*G sind in einer Ausführungsform unabhängig voneinander ausgewählt aus der Gruppe bestehend aus: 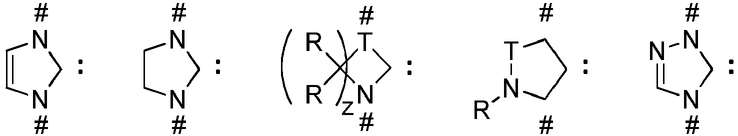 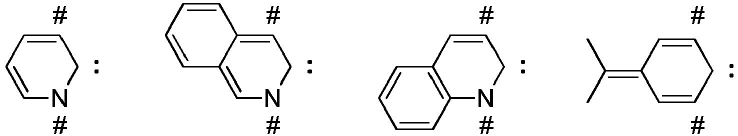 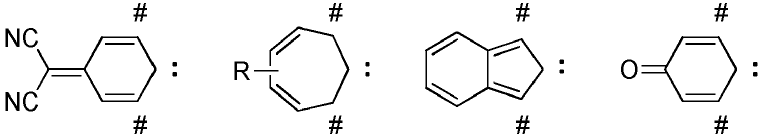 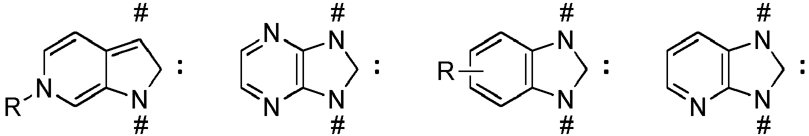
wobei die zwei Punkte ":" für ein divalentes Carben-Kohlenstoffatom stehen, das an das Metall koordiniert, und die Verknüpfung von Q mit Z und Y mit Z an einer der mit # gekennzeichneten Stellen stattfindet und somit A und G das andere Nachbaratom des Carben-Kohlenstoffatoms darstellt, das dann direkt mit der Spacereinheit S" oder S' verbunden ist;
jedes weitere R ist unabhängig voneinander ebenfalls ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
und z für die ganzen Zahlen 1, 2, 3 oder 4 steht.

Der tetradentate Ligand L kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Durch die Koordination des tetradentaten Liganden L wird die Stabilität und Rigidität des Metall(I)komplexes stark erhöht. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Die Erfindung betrifft Metall(I)komplexe aufweisend eine Struktur ausgewählt aus der Gruppe bestehend aus 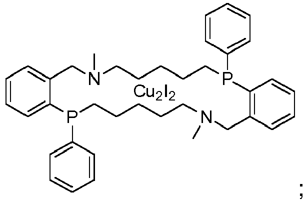 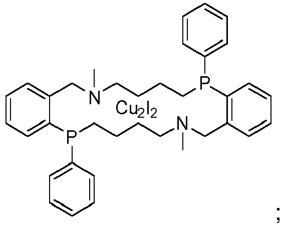 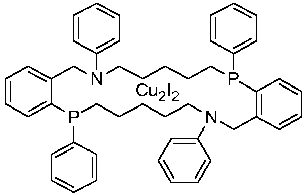 und 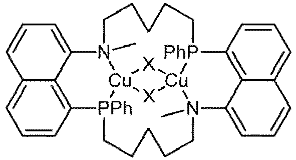 mit X gleich Cl, Br, I oder CN.

Hinsichtlich ihrer Verwendung in optoelektronischen Bauelementen zeichnen sich die erfindungsgemäßen Metall(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Metall(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

In einer Ausführungsform handelt es sich bei der Untereinheit EnD des Liganden L in den Formeln A und I bis IX um folgende Liganduntereinheiten: 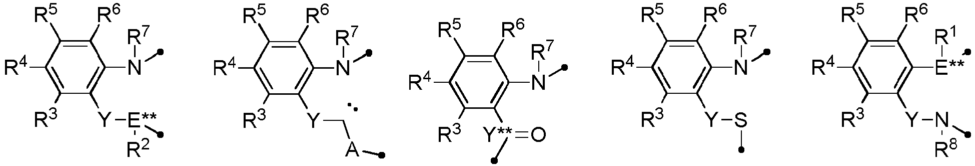 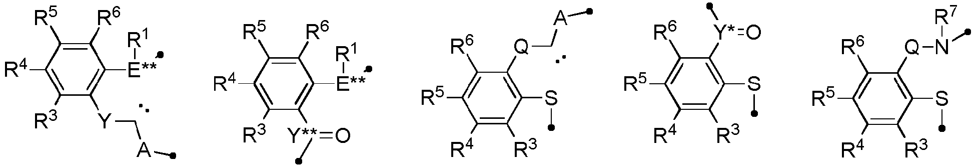 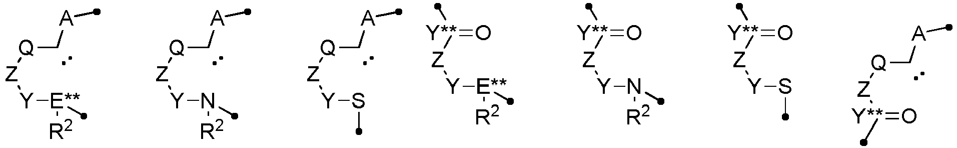 mit
E** = ausgewählt aus der Gruppe bestehend aus P, As und Sb,
: = ein Carben-Kohlenstoffatom,
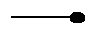 kennzeichnet die direkte Verbindungsstelle mit der Spacereinheit S" und S', wobei sowohl gleiche als auch verschiedene Untereinheiten E∩D über die Spacereinheit S" und S' verbunden sein können (hierdurch entstehen unsymmetrische makrozyklische Liganden L),
A = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
A und Q und G und Y können optional jeweils miteinander verbunden sein, sodass sich ein Imidazolidin- oder ein Imidazolderivat ausbildet und/oder mit der Einheit Z und/oder den Resten R³-R⁸ auch zu annelierten Ringsystemen führen,
Y** = unabhängig voneinander ausgewählt aus der Gruppe bestehend aus C, PR, S, S(O);
R = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. R³-R⁸ können optional auch zu annelierten Ringsystemen führen.

In einer Ausführungsform handelt es sich bei dem Liganden L in den Formeln A und I bis IX um folgende Liganden, wobei die oben aufgeführten Definitionen gelten:

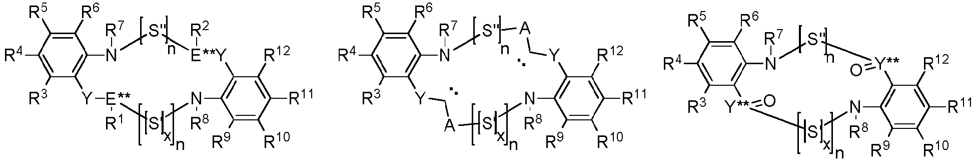

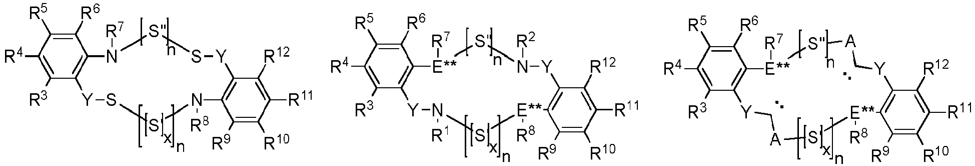

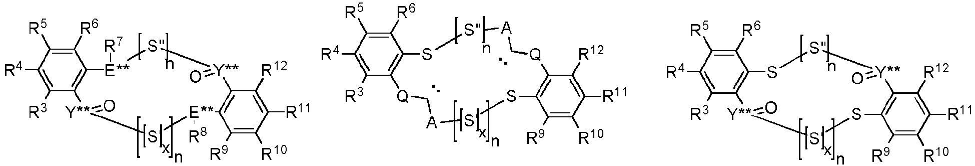

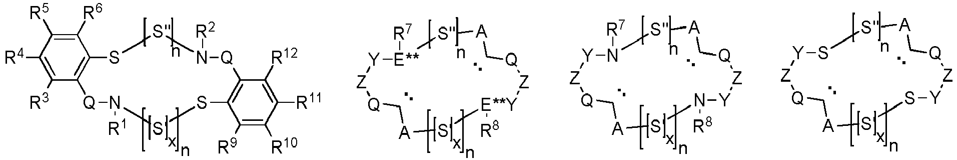

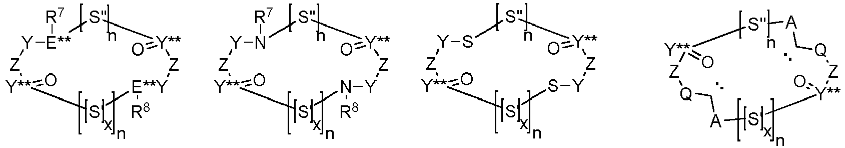

Die Neutralität der Kupfer(I)-Komplexe der Formeln A bis IX wird gewährleistet, da beide Cu(I)-Ionen einfach positiv und die zwei überbrückenden Liganden X, die jeweils an beide Cu(I)-Ion gebunden sind, einfach negativ geladen sind. Die zweikernigen neutralen Kupfer(I)-Komplexe weisen demgemäß zwei einfach negativ geladene überbrückende Liganden X und einen neutralen tetradentaten Liganden L, der über je zwei Donoratome der zwei gleichen oder verschiedenen Untereinheiten EnD an ein Cu(I)-Ion koordiniert, auf.

Die Liganden X sind insbesondere monoanionische überbrückende Liganden, die jeweils an beide Metall(I)-Ionen gebunden sind. Die zwei Untereinheiten EnD des tetradentaten Liganden L sind bidentat, weisen also zwei Koordinationsstellen auf, und koordinieren mit beiden Koordinationsstellen an dasselbe Metall M<1> oder M<2>.

Geeignete monoanionische Liganden X sind ausgewählt aus Cl, Br und I, Azid, Alkylalkinylen, wie z. B. Methyl-C≡C⁻, tert-Butyl-C≡C⁻, Aryl- bzw. Heteroarylalkinylen, wie z. B. Phenyl-C≡C⁻, Cyanid, Cyanat, Isocyanat, Thiocyanat, Isothiocyanat, aliphatischen oder aromatischen Thioalkoholaten, wie z. B. Methanthiolat, Ethanthiolat, Propanthiolat, iso-Propanthiolat, tert-Thiobutylat, Thiophenolat. Dabei sind die Alkylgruppen in diesen Gruppen insbesondere C1-C20-Alkylgruppen, insbesondere C1-C10-Alkylgruppen, insbesondere C1-C4-Alkylgruppen. Unter einer Arylgruppe werden auch Heteroarylgruppen verstanden. Diese Gruppen sind wie oben definiert.

Die oben beschriebenen Komplexe gemäß Formel A und I bis X bzw. die oben aufgeführten Ausführungsformen werden in der organischen Elektrolumineszenzvorrichtung als aktive Komponente verwendet. Aktive Komponenten sind generell die organischen, metallorganischen oder anorganischen Materialien, welche zwischen Anode und Kathode eingebracht sind, beispielsweise Ladungsinjektions-, Ladungstransport- oder Ladungsblockiermaterialien, Emissionsmaterialien und Matrixmaterialien. Insbesondere als Emissionsmaterialien zeigen die erfindungsgemäßen Verbindungen besonders gute Eigenschaften, wie im Folgenden noch näher ausgeführt wird. Eine Ausführungsform der Erfindung sind daher organische Elektrolumineszenzvorrichtungen enthaltend mindestens eine erfindungsgemäße Verbindung in einer Emissionsschicht.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockier-schichten, Ladungserzeugungsschichten (Charge Generation Layers) und/oder organische oder anorganische p/n-Übergänge. Ebenso können zwischen zwei emittierende Schichten Interlayers eingebracht sein, welche beispielsweise eine Exzitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Anspruch 1 enthält. Wenn mehrere Emissionsschichten vorhanden sind, weisen diese insbesondere insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die eine thermisch aktivierte verzögerte Fluoreszenz zeigen. Insbesondere können Dreischichtsysteme vorteilhaft sein, wobei die drei Schichten blaue, grüne und orange oder rote Emission zeigen (für den prinzipiellen Aufbau siehe z. B. WO 05/011013).

Wenn die Verbindung gemäß Formel A als emittierende Verbindung in einer emittierenden Schicht eingesetzt wird, wird sie insbesondere in Kombination mit einem oder mehreren Matrixmaterialien eingesetzt. Die Mischung aus der Verbindung gemäß Formel A und dem Matrixmaterial enthält zwischen 1 und 99 Vol.-%, in einer Ausführungsform zwischen 2 und 90 Vol.-%, in einer weiteren Ausführungsform zwischen 4 und 85 Vol.-%, insbesondere zwischen 5 und 80 Vol.-% der Verbindung gemäß Formel A bezogen auf die Gesamtmischung aus Emitter und Matrixmaterial. Entsprechend enthält die Mischung zwischen 99 und 1 Vol.-%, in einer Ausführungsform zwischen 98 und 10 Vol.-%, insbesondere zwischen 96 und 15 Vol.-%, insbesondere zwischen 95 und 20 Vol.-% des Matrixmaterials bezogen auf die Gesamtmischung aus Emitter und Matrixmaterial.

Da die Verbindungen gemäß Formel A im Allgemeinen hohe Glasübergangstemperaturen aufweisen, eignen sie sich weiterhin auch zum Einsatz als Reinschicht ohne die Verwendung eines Matrixmaterials. Somit enthält die emittierende Schicht in einer Ausführungsform ausschließlich die Verbindung gemäß Formel A, d. h. in einer Konzentration von 100%, und somit keinerlei weiteres Matrixmaterial.
Geeignete Matrixmaterialien sind Ketone, Phosphinoxide, Sulfoxide und Sulfone, z. B. gemäß WO 04/013080, WO 04/093207, WO 06/005627 oder der DE 102008033943 A, Triarylamine, Carbazolderivate, z. B. CBP (N,N-Biscarbazolylbiphenyl) oder die in WO 05/039246, US 2005/0069729, JP 2004/288381 , EP 1205527 oder WO 08/086851 offenbarten Carbazolderivate, Indolocarbazolderivate, z. B. gemäß WO 07/063754 oder WO 08/056746, Azacarbazole, z. B. gemäß EP 1617710, EP 1617711 , EP 1731584, JP 2005/347160, bipolare Matrixmaterialien, z. B. gemäß WO 07/137725, Silane, z. B. gemäß WO 05/111172, Azaborole oder Boronester, z. B. gemäß WO 06/117052, Triazinderivate, z. B. gemäß der DE 102008036982, WO 07/063754 oder WO 08/056746, oder Zinkkomplexe, z. B. gemäß EP 652273 oder gemäß der DE 102007053771. Es kann auch vorteilhaft sein, eine Mischung aus mehreren Matrixmaterialien als gemischte Matrix für die Verbindung gemäß Formel A zu verwenden. In einer Ausführungsform hat eine Komponente der Matrix dann elektronenleitende Eigenschaften, ist also beispielsweise ein aromatisches Keton oder ein Triazinderivat, und die andere Komponente der Matrix hat lochleitende Eigenschaften, ist also beispielsweise ein Carbazolderivat oder ein Arylamin.

In einer weiteren Ausführungsform der Beschreibung wird die erfindungsgemäße Verbindung als Co-Host für eine weitere lumineszierende Verbindung, die bei längerer Wellenlänge emittiert, verwendet. Dabei können als lumineszierende Verbindung, welche bei längerer Wellenlänge emittiert, generell alle lumineszierende Materialien, wie sie gemäß dem Stand der Technik bekannt sind, verwendet werden. So kann eine Verbindung der Formel A, welche im blauen Bereich emittiert, als Co-Host für eine grün lumineszierende Verbindung eingesetzt werden und eine Verbindung, welche im grünen Bereich emittiert, als Co-Host für eine rot lumineszierende Verbindung. Als weiterer Co-Host wird in einer Ausführungsform ein elektronenleitendes Matrixmaterial eingesetzt. Ein solcher Device-Aufbau ist beispielsweise allgemein in der Anmeldung DE 102008063470 A1 offenbart.

Ein weiterer Aspekt der Erfindung betrifft eine organische Elektrolumineszenzvorrichtung, bei der eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.
Die Erfindung betrifft auch eine organische Elektrolumineszenzvorrichtung, bei der eine oder mehrere Schichten mit dem OVPD (Organic Vapor Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapor Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin betrifft die Erfindung ist eine organische Elektrolumineszenzvorrichtung, bei der eine oder mehrere Schichten aus Lösung, wie z. B. durch Spincoating, oder mit einem beliebigen Druckverfahren, wie z. B. Siebdruck, Flexodruck oder Offsetdruck, insbesondere LITI (Light Induced Thermal Imaging, Thermotransferdruck) oder InkJet Druck (Tintenstrahldruck), hergestellt werden. Da die Verbindungen gemäß Formel A im Allgemeinen eine gute Löslichkeit in den gängigen organischen Lösemitteln aufweisen, eignen sie sich gut für die Verarbeitung aus Lösung. Diese Verfahren sind dem Fachmann generell bekannt und können von ihm ohne Probleme auf organische Elektrolumineszenzvorrichtungen enthaltend Verbindungen gemäß Formel A bzw. die oben aufgeführten Ausführungsformen angewandt werden.

Die erfindungsgemäßen Metall(I)komplexe zeichnen sich durch folgende überraschende Vorteile gegenüber dem Stand der Technik aus:
1. Die erfindungsgemäßen Verbindungen weisen sowohl eine hohe thermische Stabilität auf und sind neutral, eignen sich also gut für die Verarbeitung aus der Gasphase, weisen aber auch eine hohe Löslichkeit in einer großen Bandbreite organischer Lösemittel auf und sind daher auch sehr gut für die Verarbeitung aus Lösung geeignet.
2. Organische Elektrolumineszenzvorrichtungen enthaltend erfindungsgemäße Verbindungen als emittierende Materialien weisen eine exzellente Lebensdauer auf.
3. Es sind blau lumineszierende Komplexe zugänglich, welche eine tiefblaue Emissionsfarbe und bei Verwendung in organischen Elektrolumineszenzvorrichtungen eine hohe Lebensdauer aufweisen. Dies ist ein Fortschritt gegenüber dem Stand der Technik, da bislang bei blau phosphoreszierenden Vorrichtungen noch Verbesserungsbedarf hinsichtlich der Farbkoordinaten und insbesondere der Lebensdauer gab.
Die zweizähnige Untereinheit EnD und/oder die Spacereinheit S" oder S' kann an geeigneten Stellen mit mindestens einer Funktions-Gruppe FG substituiert sein. So können sich direkte C_{FG}-C_{E∩D} Bindungen bilden, wobei C_{E∩D} ein C-Atom des EnD Liganden darstellt und C_{FG} ein C-Atom der Funktions-Gruppe. Ist das anbindende Atom ein Stickstoffatom, so ergeben sich N_{FG}-C_{E∩D} Bindungen, wobei N_{FG} für das Stickstoffatom steht. Andererseits kann die Funktions-Gruppe über eine Brücke an den EnD Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{E∩D}, C_{FG}-S-C_{E∩D}, C_{FG}-C(O)-O-C_{E∩D}, C_{FG}-C(O)-NH-C_{E∩D}, C_{FG}-CH₂-C_{E∩D}, C_{FG}-SiR'₂-C_{E∩D}C_{N*∩E}, C_{FG}-CH=CH-C_{E∩D}, C_{FG}-C≡C-C_{E∩D}, N_{FG}-CH₂-C_{E∩D}.

Die Verfahren zur Verknüpfung der Funktionsgruppe an den EnD Ligand und/oder die Spacereinheit S" oder S', entweder direkt oder über eine Brücke, sind dem Fachmann bekannt (Suzuki-, Still-, Heck-, Sonogashira-, Kumada-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R in den Formeln A bis IX auch ein elektronenleitender, lochleitender oder die Löslichkeit erhöhender Substituent sein.

Die Beschreibung betrifft auch ein Verfahren zur Herstellung eines erfindungsgemäßen Metall(I)komplexes. Dieses Verfahren weist den Schritt des Durchführens einer Reaktion des tetradentaten Liganden L mit M(I)X auf,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl, Thiolat und N₃,
L = ein tetradentater Ligand, zusammengesetzt aus zwei gleichen oder verschiedenen Untereinheiten E∩D, die über eine Spacereinheit S" und optional S' verbunden sind, mit
E = RE* (wenn E* = N, P, As, Sb) oder E* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RD* (wenn D* = N, P, As, Sb) oder D* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Der optional am Liganden L vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird in einer Ausführungsform in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyltert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von tetradentaten L-Liganden mit M(I)X (M = Ag, Cu; X = Cl, Br, I), insbesondere in Dichlormethan (DCM), insbesondere bei Raumtemperatur, entsteht der zweikernige 2:1-Komplex M₂X₂L, in dem jedes Metallatom durch je eine Untereinheit E∩D des tetradentaten Liganden L zweifach koordiniert sowie durch die beiden Halogenid-Anionen überbrückt wird (Gl. 1).

Die Stabilität des hier beschriebenen Komplexes ist durch Verwendung eines tetradentaten Liganden L sehr groß (erkennbar beispielsweise durch Absorptions- und Emissionsmessungen des Komplexes in Lösung und als Filme) und zusätzlich die Rigidität des Komplexes stark erhöht. Der Komplex kann durch Fällen mit Et₂O als weißes, gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

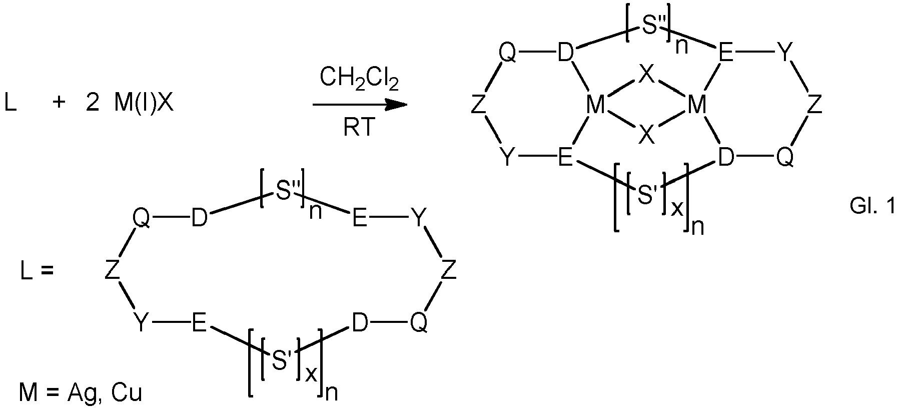

Hierbei handelt es sich um die oben aufgeführte allgemeine Formel A.

Substituenten zur Einführung unterschiedlicher Funktionalitäten
Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports können entweder einfach oder mehrfach am L-Liganden gebunden sein. Es können identische oder unterschiedliche Funktions-Gruppen verwendet werden. Die Funktions-Gruppen können symmetrisch oder unsymmetrisch vorhanden sein.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumada-, Ullmann-, Buchwald-Hartwig-Kupplung sowie deren Varianten zu Einsatz.

Dabei geht man von einem mit Halogenid (Cl, Br, I), insbesondere Br, substituierten EnD-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und L-Ligand. Bei Anwesenheit von -OH Gruppen kommen hier z. B. Veresterungen und Etherbildung in Frage, bei -NH₂ Gruppen Imin- und Amidbildung, bei - COOH Gruppen Esterbildung. Entsprechend muss das Substitutionsmuster des L-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

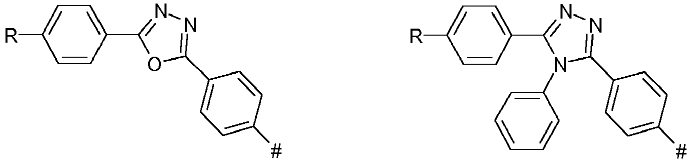

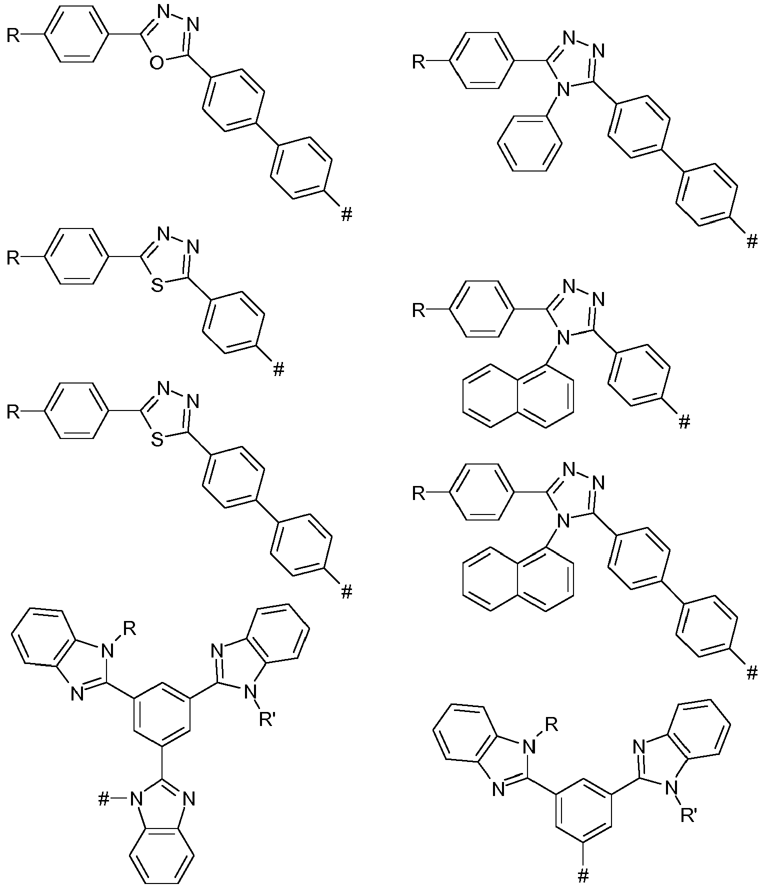

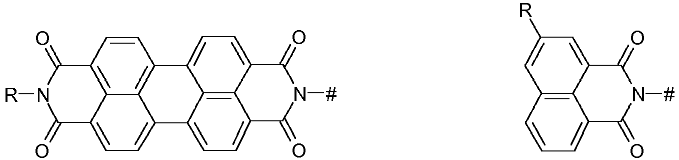

Bei den Substituenten R und R' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR"'₃) oder Ethergruppen -OR"' (R"' definiert wie R; die hier verwendeten Substituenten entsprechen nicht notwendiger Weise den Substituenten R und/oder R' der Formel A oder der Formeln I bis IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den L-Liganden am einfachsten durch Palladium-katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

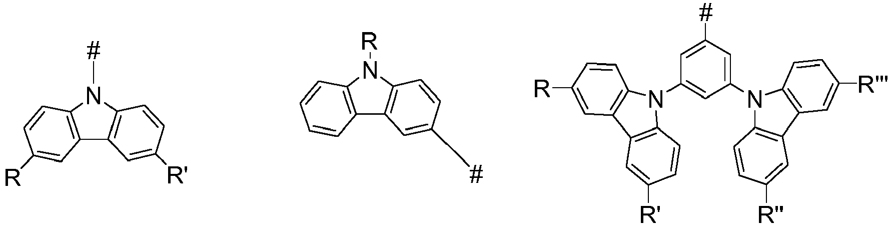

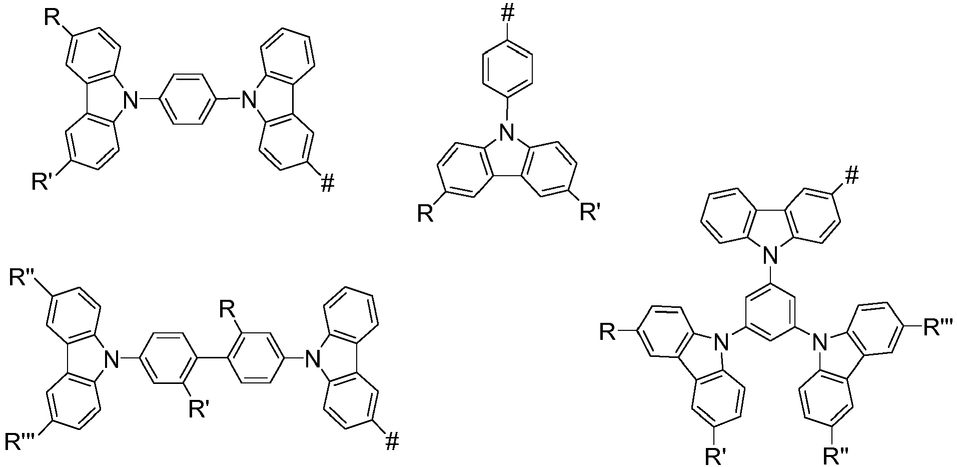

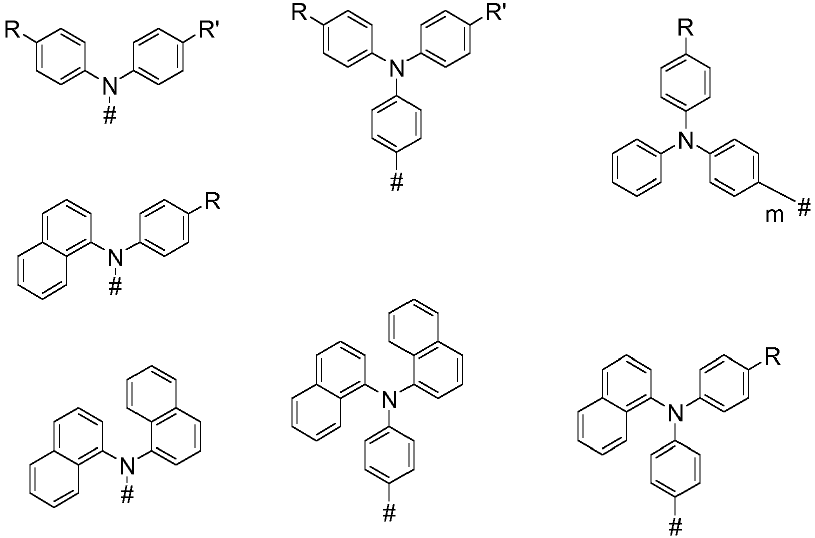

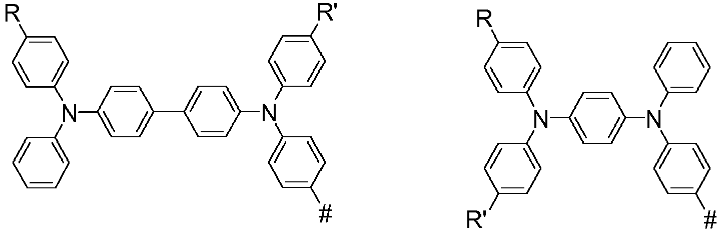

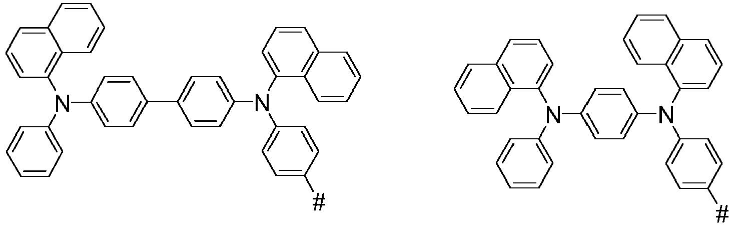

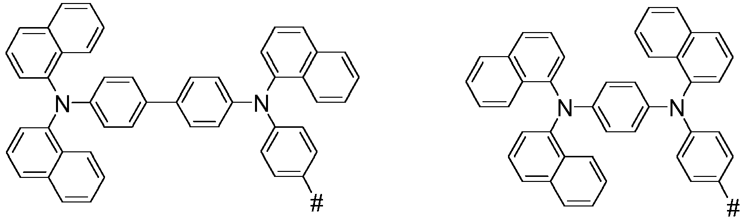

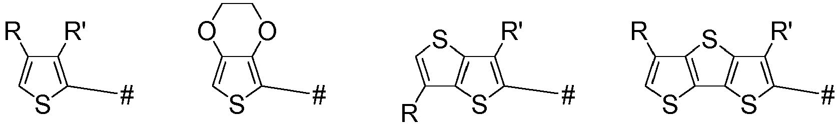

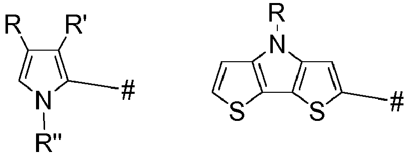

Bei den oben gezeigten Substituenten R, R" und R"' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""₃) oder Ethergruppen -OR"" (R"" definiert wie R; die oben für die Lochtransport-Substituenten verwendeten Substituenten entsprechen nicht notwendiger Weise den Substituenten R und/oder R' der Formel A oder der Formeln I bis IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

Zur Verwendung der Metall(I)-Komplexe als selbstkatalysierende Emittermaterialien zur Erzielung einer Quervernetzung mit einem zweiten Reaktanden können solche Funktionalitäten in der Peripherie des L-Liganden angebracht werden, die mit der entsprechend komplementären funktionellen Einheit des zweiten Reaktanden eine durch den Metall(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird. Beispielhaft für eine selbstkatalysierte Quervernetzungsreaktion ist die Kupfer-katalysierte Click-Reaktion zwischen einem terminalen oder aktivierten Alkin als erster Click-Gruppe und einem Azid als zweiter Click-Gruppe. Da der Metallkomplex-Emitter in dieser Ausführungsform mindestens zwei Alkin-Einheiten tragen muss, sind mindestens zwei der Untereinheiten D, E, Q, Y, Z in einer Ausführungsform mit mindestens je einer der oben genannten funktionellen Gruppe zur Erzielung einer Quervernetzung substituiert, während die für die Quervernetzung nicht aktiven übrigen Untereinheiten D, E, Q, Y, Z, die nicht mit mindestens je einer der oben genannten funktionellen Gruppe zur Erzielung einer Quervernetzung substituiert sind, optional mit einer anderen der oben genannten funktionellen Gruppe zur Erhöhung der Löslichkeit des Komplexes in organischen Lösungsmitteln und/oder zur Verbesserung des Ladungsträgertransports substituiert sein kann. Somit können unterschiedliche Funktionalitäten über die Peripherie der verschiedenen Liganden eingeführt werden (beispielsweise je eine Lochtransport- und Elektrontransport-Einheit zur Erzielung eines optimalen Ladungsträgertransports und/oder ein Substituent zur Erhöhung der Löslichkeit des Komplexes in organischen Lösungsmitteln und/oder eine funktionelle Gruppe zur Erzielung einer Quervernetzung), wodurch eine sehr flexible Anpassung und Modifizierung der Metall(I)-Komplexe möglich ist.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R¹-R¹² so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R¹-R¹² erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ- (n = 2 - 500). Weitere unpolare Gruppen sind: Ether -OR*, Thioether -SR*, unterschiedlich substituierte Silane R*₃Si-(R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O),- (n > 20); Oligo/polyphosphazene R**(-R*₂P=N-)ₙ- (n = 1 - 200).

### Löslichkeit in polaren Medien

Polare Substitutenten R¹-R¹² erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
   -COOH, -P(O)(OH)₂, -P(S)(OH)₂, -S(O)(OH)₂, -COOR*, -P(O)(OR*)₂, -P(S)(OR*)₂,-S(O)(OR*)₂, -CONHR*, -P(O)(NR*₂)₂, -P(S)(NR*₂)₂, -S(O)(NR*₂)₂
   - Sulfoxide: -S(O)R*, -S(O)₂R*
   - Carbonylgruppen: -C(O)R*
   - Amine: -NH₂, -NR*₂, -N(CH₂CH₂OH)₂,
   - Hydroxylamine =NOR*
   - Oligoester, -O(CH₂O-)ₙ, -O(CH₂CH₂O-)ₙ (n = 2 - 200)
   - Positiv geladene Substituenten: z. B. Ammonium-Salze -N⁺R*₃X⁻, Phosphonium-Salze-P⁺R*3X⁻
   - Negativ geladene Substituenten, z. B. Borate -(BR*₃)⁻, Aluminate -(AIR*₃)⁻ (als Kation kann ein Alkalimetal oder Ammoniumion fungieren).

Optional kann das Darstellungsverfahren den Schritt umfassen, dass der Ligand L mit mindestens einem der oben genannten Substituenten zur Erhöhung der Löslichkeit in einem organischen Lösungsmittel substituiert wird, wobei der Substituent in einer Ausführungsform ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass der Ligand L mit mindestens einer der o. g. funktionellen Gruppe zur Verbesserung des Ladungsträgertransports substituiert wird, wobei die funktionelle Gruppe an einer Untereinheit E∩D gleich oder verschieden sein kann von der funktionellen Gruppe an der anderen Untereinheit E∩D, insbesondere verschieden, wobei der Substituent in einer Ausführungsform ausgewählt sein kann aus der Gruppe bestehend aus Elektronenleiter und Lochleiter.

Die erfindungsgemäßen Metall(I)komplexe können erfindungsgemäß als Emitter-Materialien in einer Emitterschicht eines Licht-emittierenden optoelektronischen Bauelements eingesetzt werden.

Die erfindungsgemäßen Metall(I)komplexe können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Metall(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Metall(I)komplexes in der Emitter- oder Absorber-Schicht 1 % bis 99 %.

Vorteilhafter Weise beträgt die Konzentration des Metall(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen erfindungsgemäßen Metall(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Lichtemittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Metall(I)komplex der hier beschriebenen Art verwendet wird. Bei diesem Verfahren wird insbesondere ein erfindungsgemäßer Metall(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Metall(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Metall(I)komplex ein erfindungsgemäßer Metall(I)komplex ist. Erstes und zweites Lösungsmittel sind dabei nicht identisch.

Die Beschreibung betrifft in einem Aspekt ein Verfahren zur Veränderung der Emissions- und/oder Absorptionseigenschaften eines elektronischen Bauelements. Dabei wird ein erfindungsgemäßer Metall(I)komplex in ein Matrixmaterial zur Leitung von Elektronen oder Löchern in ein optoelektronisches Bauelement eingebracht.

Die Beschreibung betrifft in einem weiteren Aspekt auch die Verwendung eines erfindungsgemäßen Metall(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist in einer Ausführungsform ein erfindungsgemäßer Metall(I)komplex.

Die Erfindung betrifft auch ein optoelektronisches Bauelement, aufweisend ein Substrat, und mindestens eine lichtemittierende Schicht, die eine erfindungsgemäße Verbindung aufweist, wobei die lichtemittierende Schicht auf das Substrat aufgebracht ist.

In einer Ausführungsform weist das optoelektronische Bauelement ein Substrat, eine Anode, eine Kathode und mindestens eine lichtemittierende Schicht auf, die eine erfindungsgemäße Verbindung aufweist, wobei die Anode und die Kathode auf das Substrat aufgebracht wird, und die lichtemittierende Schicht zwischen Anode und Kathode aufgebracht wird.

In einer Ausführungsform weist das optoelektronisches Bauelement ein Substrat, eine Anode, eine Kathode und mindestens eine lichtemittierende Schicht auf, die ausschließlich eine erfindungsgemäße Verbindung in 100% Konzentration aufweist, wobei die Anode und die Kathode auf das Substrat aufgebracht wird, und die lichtemittierende Schicht zwischen Anode und Kathode aufgebracht wird.

In einer Ausführungsform weist das optoelektronisches Bauelement ein Substrat, eine Anode, eine Kathode und mindestens eine lichtemittierende Schicht auf, die eine erfindungsgemäße Verbindung und ein Hostmaterial aufweist, dessen Triplett (T1)- und Singulett (S1)-Energieniveaus energetisch höher liegen als die Triplett (T1)- und Singulett (S1)-Energieniveaus der erfindungsgemäßen Verbindung, wobei die Anode und die Kathode auf das Substrat aufgebracht wird, und die lichtemittierende Schicht zwischen Anode und Kathode aufgebracht wird.

In einer weiteren Ausführungsform weist das optoelektronisches Bauelement ein Substrat, eine Anode, eine Kathode und mindestens je eine löcher- und elektroneninjizierende Schicht, und mindestens je eine löcher- und elektronentransportierende Schicht, und mindestens eine lichtemittierende Schicht auf, die eine erfindungsgemäße Verbindung und ein Hostmaterial aufweist, dessen Triplett (T1)- und Singulett (S1)-Energieniveaus energetisch höher liegen als die Triplett (T1)- und Singulett (S1)-Energieniveaus der erfindungsgemäßen Verbindung, wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement ein Substrat, eine Anode, eine Kathode und mindestens je eine löcher- und elektroneninjizierende Schicht, und mindestens je eine löcher- und elektronentransportierende Schicht, und mindestens eine lichtemittierende Schicht auf, die eine erfindungsgemäße Verbindung und ein Hostmaterial aufweist, dessen Triplett (T1)- und Singulett (S1)-Energieniveaus energetisch höher liegen als die Triplett (T1)- und Singulett (S1)-Energieniveaus der erfindungsgemäße Verbindung, wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

Da die erfindungsgemäßen Metall(I)komplexe mit unsubstituierten Liganden L in einigen organischen Lösungsmitteln z. T. schwer löslich sind, können sie ggf. nicht direkt aus diesen Lösungsmitteln verarbeitet werden. Aus diesem Grund sollten die Substanzen in einer für die Anwendung in optoelektronischen Bauelementen geeigneten Größe hergestellt bzw. auf diese zerkleinert werden (< 20 nm bis 30 nm, mikrokristallines Pulver) oder mittels geeigneter Substituenten löslich gemacht werden.

Die erfindungsgemäßen Metall(I)komplexe werden insbesondere aus Lösung prozessiert. Somit erfolgt die Herstellung der photoaktiven Schichten in einer Ausführungsform aus Lösung durch Spincoating oder Schlitzgießverfahren oder mit einem beliebigen Druckverfahren wie Siebdruck, Flexodruck, Offsetdruck oder Ink-Jet-Druck.

Zur Erzielung einer besseren Löslichkeit in für eine OLED-Herstellung geeigneten Lösungsmitteln ist ein weiteres Ziel dieser Erfindung, die Emitter chemisch so zu verändern, dass diese in solchen Lösungsmitteln gut löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Um die Löslichkeit der erfindungsgemäßen Metall(I)komplexe in organischen Lösungsmitteln zu verbessern, ist optional der Ligand L mit mindestens einem der oben genannten Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3 bis 50 Wiederholungseinheiten eingesetzt werden können.

Die Alkylketten oder Alkoxylketten oder Perfluoralkylketten sind in einer Ausführungsform der Beschreibung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C3-Einheit, verzweigt oder unverzweigt oder zyklisch, erreicht.

Um den Ladungsträgertransport zu den erfindungsgemäßen Metall(I)komplexen zu verbessern, ist optional der Ligand L mit mindestens einer der oben genannten funktionellen Gruppe zur Verbesserung des Ladungsträgertransports substituiert, wobei die funktionelle Gruppe an einer Untereinheit EnD gleich oder verschieden sein kann von der funktionellen Gruppe an der anderen Untereinheit EnD, insbesondere verschieden. Der Substituent kann ausgewählt sein aus der Gruppe bestehend aus Elektronenleiter und Lochleiter.

Die Substituenten des Liganden L der Metall(I)komplexe können an jeder Stelle der Struktur angeordnet sein.

Ein weiterer Aspekt der Beschreibung betriff die Veränderung der Emissionsfarben der Metall(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
-Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)₂, -S-Alkylgruppe

Beispiele für elektronenziehende Substituenten sind insbesondere:
-Halogen, -(CO)H, -(CO)-Alkylgruppe, -(CO)O-Alkylgruppe, -(CO)OH, -(CO)Halogenid, -CF₃, -CN, - SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt.

Somit kann durch geeignete Substitutionswahl innerhalb der Grundstruktur des L-Liganden ein sehr breiter Emissionsfarbbereich eingestellt werden.

Die Veränderung der Emissionsfarben der hier beschriebenen Metall(I)komplexe kann auch durch weitere Heteroatome wie N, O, S, sowie mittels kondensierter Aromaten erfolgen.

Die Verwendung kondensierter Aromaten wie beispielsweise Naphthyl, Anthracenyl, Phenanthrenyl etc. ermöglicht Farbverschiebungen, zum Beispiel in den gelben bis tiefroten Spektralbereich. Die Erhöhung der Löslichkeit von Metall(I)komplexen mit kondensierten Aromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer Ausführungsform weist der Metall(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Für die Herstellung der erfindungsgemäßen Metall(I)komplexe als mikrokristalline Pulver können mehrere Techniken angewandt werden (A. Rössler, G. Skillas, S. E. Pratsinis, Chemie in unserer Zeit 2001, 35, 32):
*Bottom-Up*-Prozesse zur Synthese von mikrokristallinem Pulver:
- schnelle Injektion der Reaktionslösung in einen großen Überschuss eines geeigneten Fällungsmittel (z. B. Pentan, Diethylether). (Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738)
- Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
- Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
- Co-Abscheidung der Komplexe und des Matrixmaterials auf dem Substrat direkt aus der Reaktionslösung.
- Synthese im Ultraschall-Bad.

*Top-Down*-Prozesse zur Zerkleinerung der Substanzen:
- Zerkleinerung durch Hochenergiekugelmühlen.(Y. Chen, J. F. Gerald, L. T. Chadderton, L. Chaffron, Appl. Phys. Lett. 1999, 74, 278)
- Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der mikrokristallinen Pulver in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und das mikrokristalline Pulver auf ein Substrat aufgebracht werden. Um eine Aggregation der mikrokristallinen Pulver zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen auch als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

### Figuren

- **Figur 1:**: Prinzipieller Aufbau eines OLEDs. Die Abbildung ist nicht maßstabsgerecht gezeichnet.

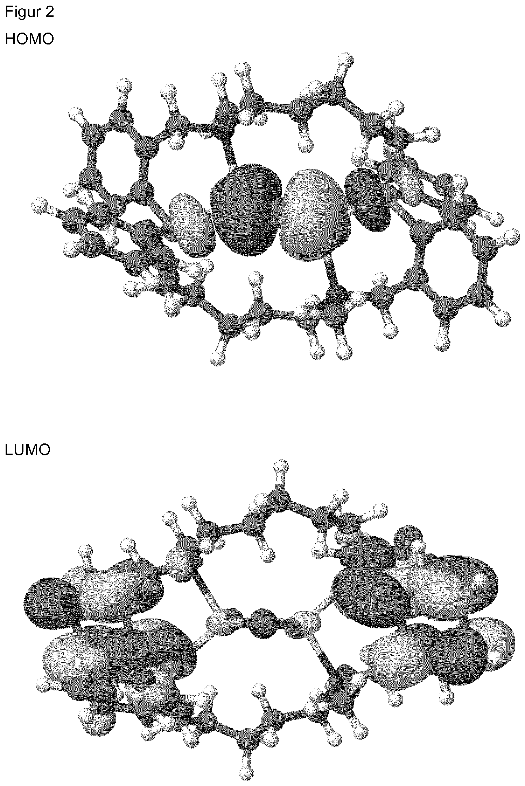

- **Figur 2:**: HOMO und LUMO von Molekül 1.

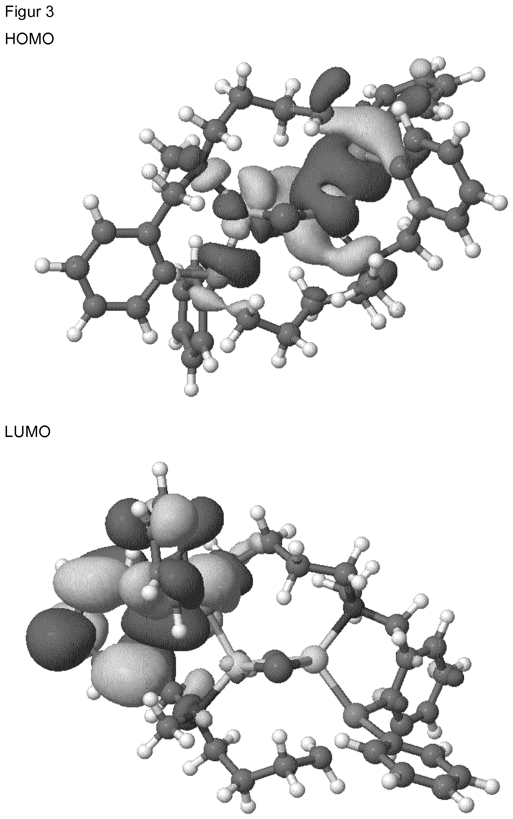

- **Figur 3:**: HOMO und LUMO von Molekül 2.

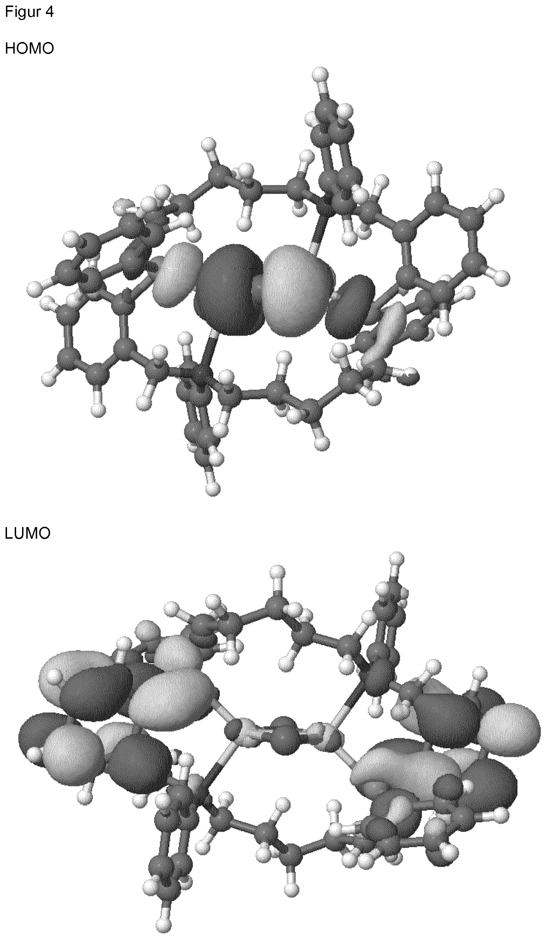

- **Figur 4:**: HOMO und LUMO von Molekül 3.

### Beispiele

### Nicht erfindungsgemäss:

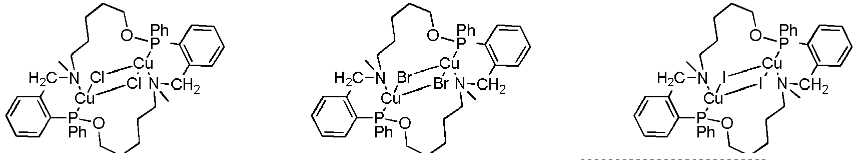

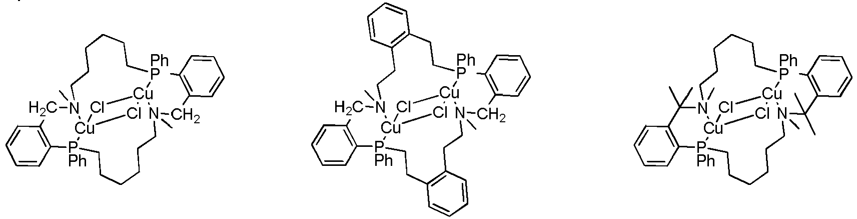

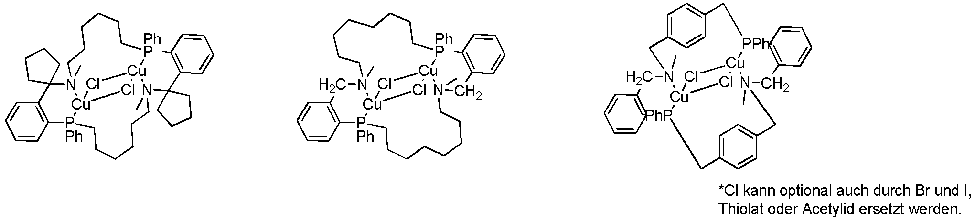

### Synthesewege:

Die gezeigten chemischen Transformationen sind einzeln betrachtet allesamt Literatur-bekannt und dem Fachmann somit bekannt, z.B. für Route 1: Bildung eines Imins aus primären Aminen und Paraformaldehyd, Umwandlung von Alkoholen in Tosyl-geschützte Alkohole, Reduktion von Iminen zu sekundären Aminen, Buchwald-Hartwig-Aminierung von sekundären Aminen und/oder Phosphinen zu tertiären Aminen und/oder Phosphinen, Zyklodimerisierung (Templat-gestützt in Gegenwart von CuCl oder durch Zyklisierung unter Ultrahochverdünnungs-Bedingungen mittels Spritzenpumpe).
Route 1: 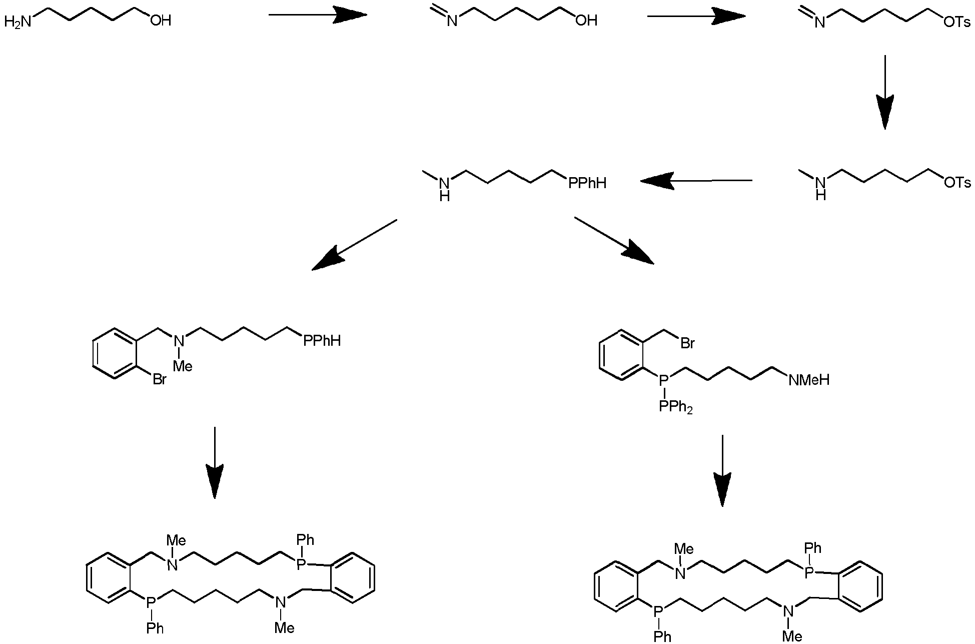
Route 2:

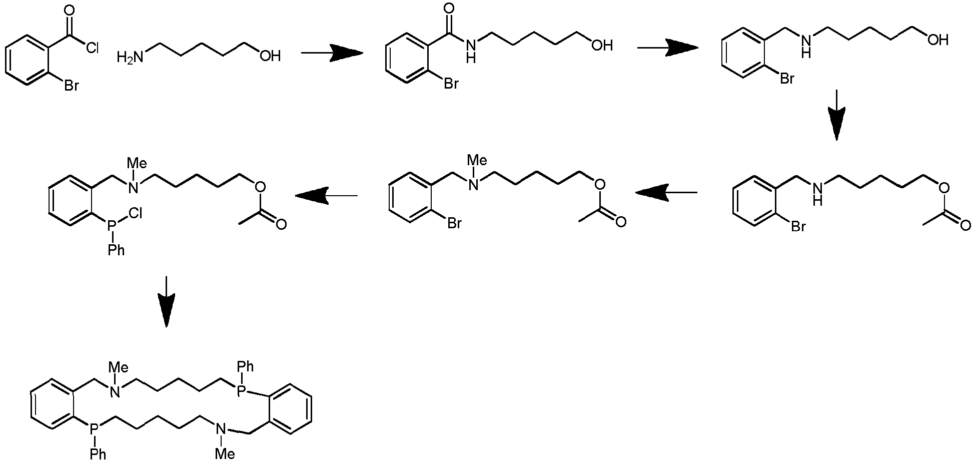

### -Ergebnisse

### Erfindungsgemäss:

| **I. Molekül 1** | **II. Molekül 2** | **III. Molekül 3** |
|---|---|---|
| 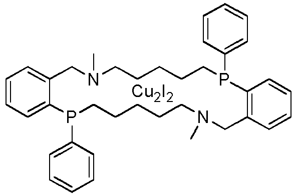 | 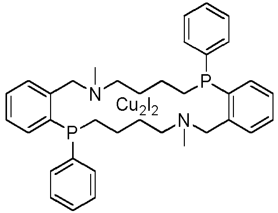 | 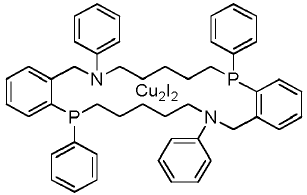 |

**Molekül 1**

| | |
|---|---|
| E_{HOMO} | -3.796 eV |
| E_{LUMO} | -1.795 eV |
| E_{Gap} | 2.001 eV |
| Dipolmoment | 0.005 D |
| E_{Ionisation} (vert.) | 5.822 eV |
| E_{Triplett} ΔSCF | 2.622 eV |
| E_{Phosphoreszenz} ΔSCF | 2.198 eV |
| λ_{Phosphoreszenz} ΔSCF | 564 nm |
| Cu-Cu-Abstand (S₀) | 2.59 Å |
| Cu-Cu-Abstand (T₁) | 2.79 Å |

**Molekül 2**

| | |
|---|---|
| E_{HOMO} | -3.777 eV |
| E_{LUMO} | -1.908 eV |
| E_{Gap} | 1.869 eV |
| Dipolmoment | 1.620 D |
| E_{Ionisation} (vert.) | 5.682 eV |
| E_{Triplett} ΔSCF | 2.545 eV |
| E_{Phosphoreszenz} ΔSCF | 2.069 eV |
| λ_{Phosphoreszenz} ΔSCF | 599 nm |
| Cu-Cu-Abstand (S₀) | 2.47 Å |
| Cu-Cu-Abstand | (T₁) 2.42 Å |

**Molekül 3**

| | |
|---|---|
| E_{HOMO} | -3.869 eV |
| E_{LUMO} | -1.824 eV |
| E_{Gap} | 2.045 eV |
| Dipolmoment | 0.006 D |
| E_{Triplett} ΔSCF | 2.863 eV |
| E_{Phosphoreszenz} ΔSCF | 2.131 eV |
| λ_{Phosphoreszenz} ΔSCF | 582 nm |
| Cu-Cu-Abstand (S₀) | 2.60 Å |
| Cu-Cu-Abstand (T₁) | 2.85 Å |

### Strukturelle Details:

### Planare Cu₂I₂-Einheit

Grundzustandsstruktur von Molekül 1 als Beispiel:

| | |
|---|---|
| Cu-Cu-Abstand | 2.59 Å |
| Cu-I-Abstand | 2.74 Å / 2.64 Å |
| I-Cu-Cu-I- | 180° |
| Diederwinkel | |
| Cu-N | 2.42 Å |
| Cu-P | 2.28 Å |
| N-Cu-P-Winkel | 99° |

### Details zur Rechenmethode:

Für die Bestimmung der HOMO-/LUMO-Lagen wurde Dichtefunktionaltheorie (DFT) unter Verwendung des BP86-Funktionals (Becke, A. D. Phys. Rev. A1988, 38, 3098-3100; Perdew, J. P. Phys. Rev. B1986, 33, 8822-8827) und des def2-SV(P)-Basissatzes (Weigend, F.; Ahlrichs, R. Phys. Chem. Chem. Phys. 2005, 7, 3297-3305; Rappoport, D.; Furche, F. J. Chem. Phys. 2010, 133, 134105/1-134105/11) verwendet. Zur numerischen Integration kam das m4-Grid zum Einsatz und die resolution-of-identity-Näherung (RI) wurde in allen Rechnungen verwendet. (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) Die Grenzorbitale in den Beispielen wurden für die optimierten Grundzustandsgeometrien berechnet. Alle DFT-Rechnungen wurden mit dem Turbomole-Programmpaket (Version 6.5) durchgeführt. (TURBOMOLE V6.5 2013, a development of University of Karlsruhe and Forschungszentrum Karlsruhe GmbH, 1989-2007, TURBOMOLE GmbH, since 2007; available from http://www.turbomole.com)

In den weiteren hier gezeigten Beispielen sind die E∩D-Einheiten des Liganden L eine Amin-Phosphineinheit (mit E = PPh₂ und D = NMe₂ bzw. E = PPh₂ und D = N(CH₂)₄), eine Amin-Thioethereinheit (mit E = SPh und D = NMe₂), eine Phosphin-Carbeneinheit (mit E = PPh₂ und D = C*), eine Amin-Carbeneinheit (mit E = NMe₂ und D = C*) oder eine Thioether-Carbeneinheit (mit E = SPh und D = C*).

Die gestrichelt gezeichnete Doppelbindung im Carbenliganden bedeutet, dass entweder nur eine Einfachbindung vorliegt und somit ein Imidazolidin-Carben verwendet wird, oder dass alternativ eine Doppelbindung vorliegt und somit ein Imidazol-Carben eingesetzt wird.

### Weitere Beispiele für erfindungsgemässe Komplexe der Form M₂X₂L

### IV. E∩D = PhPMeNNaphtyl, S = C₅H₁₀, X = Cl, Br, I, CN: Cu₂Cl₂(PhPMeNNaphtylC₅H₁₀)₂ (4a), Cu₂Br₂(PhPMeNNaphtylC₅H₁₀)₂ (4b), Cu₂I₂(PhPMeNNaphtylC₅H₁₀)₂ (4c), Cu₂CN₂(PhPMeNNaphtylC₅H₁₀)₂ (4d)

Bei den Verbindungen **4a-d** handelt es sich um weiße, feinkristalline Feststoffe.

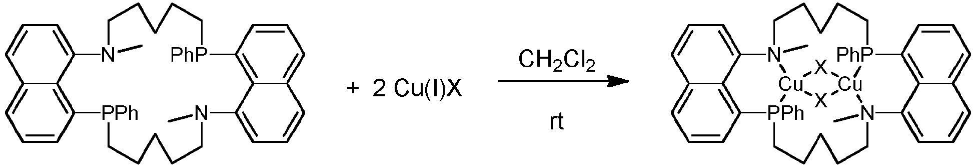

## Patentansprüche

1. Metall(I)komplex aufweisend eine Struktur ausgewählt aus der Gruppe bestehend aus 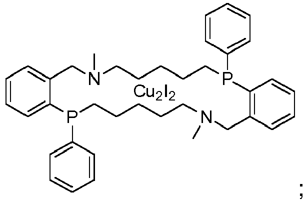 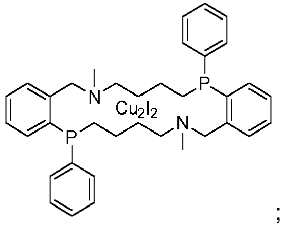 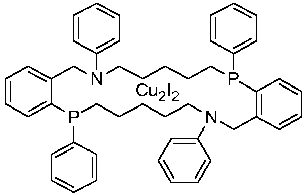 und 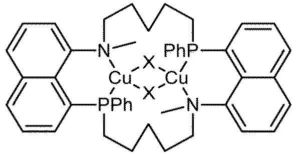 mit X gleich Cl, Br, I oder CN.

2. Verwendung eines Metall(I)komplexes nach Anspruch 1 als Emitter oder Absorber in einem optoelektronischen Bauelement, das durch ein Vakuumverdampfungsverfahren oder aus Lösung hergestellt wird, wobei das optoelektronische Bauelement insbesondere ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
Down-Konversions-Elementen.

3. Verwendung nach Anspruch 2, **dadurch gekennzeichnet, dass** der Anteil des Metall(I)komplexes am Emitter oder Absorber 100 % beträgt.

4. Verwendung nach Anspruch 3, **dadurch gekennzeichnet, dass** der Anteil des Metall(I)komplexes am Emitter oder Absorber 1 % bis 99 % beträgt.

5. Optoelektronisches Bauelement, aufweisend einen Metall(I)komplex nach Anspruch 1, wobei das optoelektronische Bauelement insbesondere ausgeformt ist als ein Bauelement ausgewählt aus der Gruppe bestehend aus organischem lichtemittierendem Bauelement, organischer Diode, organischer Solarzelle, organischem Transistor, organischer lichtemittierender Diode, Lichtemittierender elektrochemischer Zelle, organischem Feldeffekttransistor und organischem Laser.

6. Optoelektronisches Bauelement nach Anspruch 5, **dadurch gekennzeichnet, dass** der Metall(I)komplex nach Anspruch 1 als Emissionsmaterial in einer Emissionsschicht eingesetzt ist, wobei er entweder als Reinschicht oder in Kombination mit einem Matrixmaterial eingesetzt wird.

7. Lichtemittierendes Material, aufweisend einen Metall(I)komplex nach Anspruch 1 und ein Hostmaterial, wobei die Triplett (T1)- und Singulett (S1)-Energieniveaus des Hostmaterials energetisch höher liegen als die Triplett (T1)- und Singulett (S1)-Energieniveaus des Metall(I)komplexes, und wobei das lichtemittierende Material Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 2000 cm⁻¹ aufweist.

8. Verfahren zur Herstellung eines optoelektronischen Bauelements, wobei ein Metall(I)komplex nach Anspruch 1 verwendet wird.

9. Verfahren nach Anspruch 8, **gekennzeichnet durch** das Aufbringen eines Metall(I)komplexes nach Anspruch 1 auf einen Träger, wobei das Aufbringen insbesondere nass-chemisch, mittels kolloidaler Suspension oder mittels Sublimation erfolgt.

## Claims

1. Metal(I) complex, comprising a structure selected from the group consisting of 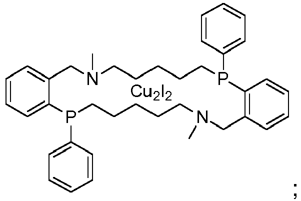 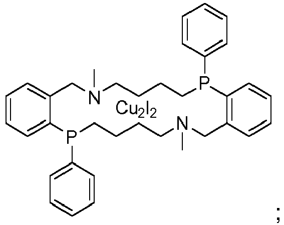 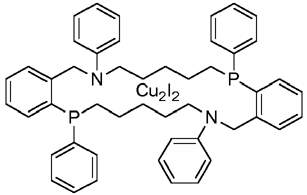 and 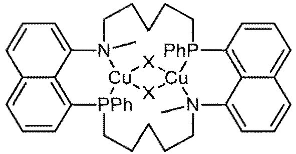 wherein X is Cl, Br, I or CN.

2. Use of a metal(I) complex according to claim 1 as an emitter or an absorber in an optoelectronic device, which is manufactured by a vacuum deposition procedure or from a solution, wherein the optoelectronic device is in particular selected from a group consisting of:
- organic light-emitting component (OLEDs),
- light-emitting electrochemical cells,
- OLED-sensors, in particular in non-hermetically shielded gas and vapor sensors,
- organic solar cells,
- organic field-effect transistors,
- organic lasers, and
- down-conversion elements.

3. Use according to claim 2, **characterized in that** the proportion of the metal(I) complex of the emitter or absorber is 100 %.

4. Use according to claim 3, **characterized in that** the proportion of the metal(I) complex of the emitter or absorber is in the range of 1 % to 99 %.

5. Optoelectronic device, comprising a metal(I) complex according to claim 1, wherein the optoelectronic device is in particular in the form of a device selected from the group consisting of organic light-emitting device, organic diode, organic solar cell, organic transistor, organic light-emitting diode, light-emitting electrochemical cell, organic field-effect transistor, and organic laser.

6. Optoelectronic device according to claim 5, **characterized in that** the metal(I) complex according to claim 1 is used as emitter material in an emission layer, wherein the metal(I) complex is used either as a pure layer or in combination with a matrix material.

7. Light-emitting material, comprising a metal(I) complex according to claim 1 and a host material, wherein the triplet (T1) and singlet (S1) energy levels of the host material are energetically higher than the triplet (T1) and singlet (S1) energy levels of the metal(I) complex, and wherein the light-emitting material emits fluorescence or thermally activated delayed fluorescence, and exhibits a deltaE(S1-T1)-value between the lowest excited singlet state (S1) and the triplet state (T1) below it of less than 2000 cm⁻¹.

8. Process for producing an optoelectronic device, wherein a metal(I) complex according to claim 1 is used.

9. Process according to claim 8, **characterized by** deposition of a metal(I) complexes according to claim 1 onto a support, wherein the deposition is carried out in particular using wet-chemical means, by colloidal suspension or by sublimation.

## Revendications

1. Complexe de métal (I) présentant une structure choisie dans le groupe constitué par 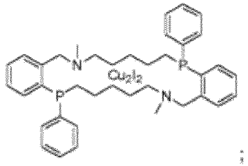 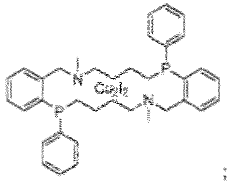 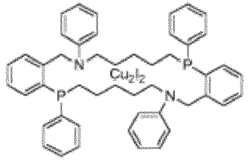 et 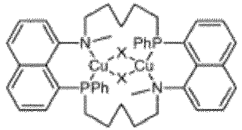 dans laquelle X représente Cl, Br, I ou CN.

2. Utilisation d'un complexe de métal (I) selon la revendication 1 comme émetteur ou absorbant dans un composant optoélectronique, qui a été fabriqué par un procédé d'évaporation sous vide ou à partir d'une solution, le composant optoélectronique étant en particulier choisi dans le groupe constitué par :
- les dispositifs électroluminescents organiques (DELO),
- les piles électrochimiques électroluminescentes,
- les capteurs à DELO, en particulier dans les capteurs de gaz et de vapeur, non hermétiquement fermés par rapport à l'extérieur,
- les piles solaires organiques,
- les transistors organiques à effet de champ,
- les lasers organiques et
- les éléments de conversion vers le bas.

3. Utilisation selon la revendication 2, **caractérisée en ce que** la proportion du complexe de métal (I) par rapport à l'émetteur ou à l'absorbant est de 100%.

4. Utilisation selon la revendication 3, **caractérisée en ce que** la proportion du complexe de métal (I) par rapport à l'émetteur ou à l'absorbant est de 1% à 99%.

5. Composant optoélectronique, présentant un complexe de métal (I) selon la revendication 1, le composant optoélectronique étant en particulier formé sous forme de composant choisi dans le groupe constitué par un composant électroluminescent organique, les diodes organiques, les piles solaires organiques, les transistors organiques, les diodes électroluminescentes organiques, les piles électrochimiques électroluminescentes, les transistors organiques à effet de champ et les lasers organiques.

6. Composant optoélectronique selon la revendication 5, **caractérisé en ce que** le complexe de métal (I) selon la revendication 1 est utilisé en tant que matériau d'émission dans une couche d'émission, où il est utilisé soit sous forme de couche pure, soit en combinaison avec un matériau de matrice.

7. Matériau électroluminescent, présentant un complexe de métal (I) selon la revendication 1 et un matériau hôte, les niveaux d'énergie triplet (T1) et singulet (S1) du matériau hôte étant énergétiquement supérieurs aux niveaux d'énergie triplet (T1) et singulet (S1) du complexe de métal (I) et le matériau électroluminescent émettant de la fluorescence ou de la fluorescence retardée, thermiquement activée et présentant une valeur deltaE(S1-T1) entre l'état de singulet excité le plus inférieur (S1) et l'état de triplet (T1) inférieur à celui-ci de moins de 2000 cm⁻¹.

8. Procédé pour la fabrication d'un composant optoélectronique, un complexe de métal (I) selon la revendication 1 étant utilisé.

9. Procédé selon la revendication 8, **caractérisé par** l'application d'un complexe de métal (I) selon la revendication 1 sur un support, l'application ayant en particulier lieu par voie chimique humide, au moyen d'une suspension colloïdale ou au moyen d'une sublimation.
